## Europäisches Patentamt

## European Patent Office

## Office européen des brevets

(11) Numéro de publication: **0 088 691**

**B1**

(12) **FASCICULE DE BREVET EUROPÉEN**

(45) Date de publication du fascicule du brevet:
15.10.86

(51) Int. Cl.⁴: **G 03 B 41/00**, G 03 F 9/00

(21) Numéro de dépôt: **83400455.8**

(22) Date de dépôt: **04.03.83**

(54) **Dispositif d'alignement pour machines de fabrication de circuits intégrés.**

(30) Priorité: **09.03.82 FR 8203959**

(43) Date de publication de la demande:
**14.09.83 Bulletin 83/37**

(45) Mention de la délivrance du brevet:
**15.10.86 Bulletin 86/42**

(84) Etats contractants désignés:
**CH DE GB IT LI NL SE**

(56) Documents cité:
**EP-A-0 017 759**
**US-A-3 794 421**
**US-A-4 103 998**
**US-A-4 315 201**

(73) Titulaire: **MATRA GCA S.A., 4, rue de Presbourg, F-75116 Paris (FR)**

(72) Inventeur: **Tigreat, Paul, 19. allée des Mitaillères, F-38240 Meylan (FR)**
Inventeur: **Berger, Laurent, 31, avenue de la Plaine Fleurie, F-38240 Meylan (FR)**
Inventeur: **Hignette, Olivier, 2, avenue de l'Europe, F-38120 Saint Egreve (FR)**

(74) Mandataire: **Fort, Jacques, CABINET PLASSERAUD 84, rue d'Amsterdam, F-75009 Paris (FR)**

## Description

La présente invention concerne le domaine des machines de fabrication de circuits intégrés et notamment de celles appelées "photorépéteurs sur tranche". Elle a plus particulièrement pour objet un dispositif d'alignement du réticule, c'est-à-dire du masque reproduisant à grande échelle l'un des tracés à réaliser successivement sur chaque puce élémentaire de la tranche, avec l'emplacement approprié sur la tranche, avant insolation d'une résine photosensible sur cette dernière.

On connaît déjà de nombreuses machines de ce type (EP-A-00 17 759 et US-A-37 94 421). Elles comportent de façon générale, une table porte-réticule portant un réticule et munie de moyens permettant de la déplacer dans son plan, au moins dans deux directions orthogonales $x$ et $y$ correspondant à deux axes principaux du réticule; une table de réception d'une tranche de semiconducteur, typiquement de silicium, portant au moins un motif d'alignement, ladite table étant équipée de moyens de déplacement suivant deux directions conjuguées des directions $x$ et $y$ ; une optique de photoréduction disposée entre les tables ; des moyens d'illumination du réticule en lumière actinique permettant d'insoler la tranche de semiconducteur à travers l'optique, et des moyens d'observation simultanée destinés à rechercher la coïncidence entre un motif d'alignement sur la tranche et un motif de référence sur le réticule et comprenant un microscope et des détecteurs, le microscope étant muni d'un élément optique qui ramène vers le microscope la lumière d'éclairage réfléchie par le réticule et la lumière d'éclairage réfléchie par la tranche à travers l'optique de photoréduction.

Il est essentiel que la machine de fabrication permette d'aligner l'image du réticule à reproduire sous une forme réduite par rapport à la tranche avec une précision élevée, de l'ordre de 0,1 μm sur la tranche. La réalisation d'un dispositif d'alignement répondant à cette condition soulève de nombreux problèmes dont la résolution est dans une certaine mesure contradictoire. Au cours de l'alignement, il faut éviter d'appliquer aux zones de la couche de résine photosensible qui recouvre la tranche une dose de lumière actinique qui impressionne la résine là où elle ne doit pas ultérieurement être insolée; si l'on tente de résoudre ce problème en utilisant, pour l'alignement, une lumière de longueur d'onde suffisamment élevée pour ne pas impressioner la résine photosensible, on se heurte au problème des aberrations chromatiques. Si par exemple l'alignement est effectué avec une première longueur d'onde (raie $e$ du mercure par exemple) tandis que l'insolation est effectuée avec une seconde longueur d'onde (raie $g$ du mercure par exemple), il est très difficile de réaliser une optique ayant exactement la même focale pour les deux longueurs d'onde.

Pour resoudre ce problème, on a réalisé des dispositif d'alignement dans lesquels le réticule est aligné par rapport à la tranche en deux étapes, en faisant intervenir une référence intermédiaire: l'alignement s'effectue pour une position fixe de la tranche par rapport au champ de l'optique de photoréduction, puis on fait subir à la table de réception de la tranche une translation dont l'amplitude et la direction correspondent à l'intervalle entre la position d'alignement et la position d'insolation. On pourra trouver une description de machines de ce genre dans de nombreux documents, tel que les brevets US-A-4 103 998, FR-A-2 408 847 et FR-A-2 482 750.

On a également proposé d'effectuer l'alignement à l'aide d'un pinceau étroit de lumière provenant de la source d'insolation, délimité par un diaphragme qui masque toute la partie du faisceau autre que celle correspondant à la zone du motif d'alignement. Ce masque est ensuite retiré pour l'insolation. On arrive ainsi à une disposition très complexe (US-A- 4 153 371).

La présente invention vise à fournir un dispositif d'alignement repondant mieux que ceux antérieurement connus aux exigences de la pratique, notammment en ce qu'il permet d'effectuer de façon simple et directe l'alignement de la tranche par rapport au réticule alors que la tranche est dans les conditions et à l'emplacement où elle sera ultérieurement insolée et sans imposer une limitation quelconque sur l'emplacement du motif d'alignement dans le circuit à réaliser (bien que ce motif soit avantageusement placé dans l'un des chemins de decoupe de la tranche).

Dans ce but, l'invention propose selon la revendication 1, notamment un dispositif dans lequel les moyens d'observation, destinés à rechercher la coïncidence entre motif de référence sur le réticule comprennent un microscope muni d'un élément optique commutable entre un état où il dégage le trajet du faisceau d'insolation et un état dans lequel il dirige un pinceau de lumière d'éclairage provenant d'une source incorporée au microscope et de même longueur d'onde que les moyens d'illumination, à travers le motif de référence, vers la tranche.

Un tel dispositif n'impose aucune limitation sur la taille du circuit élémentaire à reproduire c'est-à-dire des puces à réaliser à partir de la tranche. Le système optique associé au microscope peut comporter un miroir de renvoi déplaçable entre une position escamotée et une position d'alignement. Pour que les rayons moyens incident et réfléchi sur la tranche aient le même trajet, ce qui impose que le rayon incident passe par le foyer objet de l'optique de photoréduction, quel que soit le point du champ de cette optique qui est visé on disposera généralement, entre les moyens d'illumination et le réticule, et à proximité immédiate de ce dernier, une lentille de champ dont la focale est sensiblement égale à la distance entre le réticule et le foyer objet. Ainsi, si les rayons arrivant sur la lentille de champ à partir des moyens d'illumination sont parallèles à l'axe optique, les rayons réfractés passeront toujours par le foyer objet, quelle que soit la position du microscope. La lentille de champ influera très peu sur le grandissement et la qualité de l'image, puisqu'elle est à proximité du réticule. Son seul effet est de rabattre les rayons vers le foyer objet.

L'invention sera mieux comprise à la lecture de la description qui suit d'un dispositif qui en constitue un mode particulier de réalisation, donné à titre d'exemple non limitatif. La description se réfère aux dessins qui l'accompagnent, dans lesquels:

- la Figure 1 est un schéma de principe en perspective, des éléments optiques d'une machine de fabrication de circuits intégrés comportant un dispositif d'alignement suivant l'invention, les distances suivant l'axe optique n'étant pas respectées pour plus de clarté;

- la Figure 1a est une vue de détail à grande échelle montrant l'emplacement d'une puce (circuit élémentaire) et de ses motifs d'alignement sur la tranche;

- la Figure 2 est un schéma de principe montrant les éléments optiques du microscope de la Figure 1 et de ses éléments associés;

- les Figures 3 et 4 sont des diagrammes montrant l'allure des signaux analysés;

- la Figure 5 est un schéma montrant une variante de la Fig. 2;

- la Figure 6 est un schéma de principe montrant un fonctionnement possible en lumière polarisée permettant de diminuer le niveau de fond dû aux rétrodiffusions;

- la Figure 7 est un schéma de principe montrant un système d'analyse d'image pouvant être incorporé dans le dispositif des Figures 1 et 2;

- les Figures 8 et 9 montrent schématiquement l'utilisation d'un motif d'alignement constitué par deux réseaux et la répartition de la lumière diffractée, en vue d'un alignement suivant une seule direction;

- les Figures 10 et 11, similaires aux Figures 8 et 9, montrent l'application à l'alignement suivant deux directions orthogonales;

- la Figure 12, similaire à la Figure 5, est un schéma de principe montrant un système d'alignement à diffraction par réseau;

- la Figure 13 est un schéma de principe d'un système hybride permettant l'analyse d'image et l'analyse par diffraction.

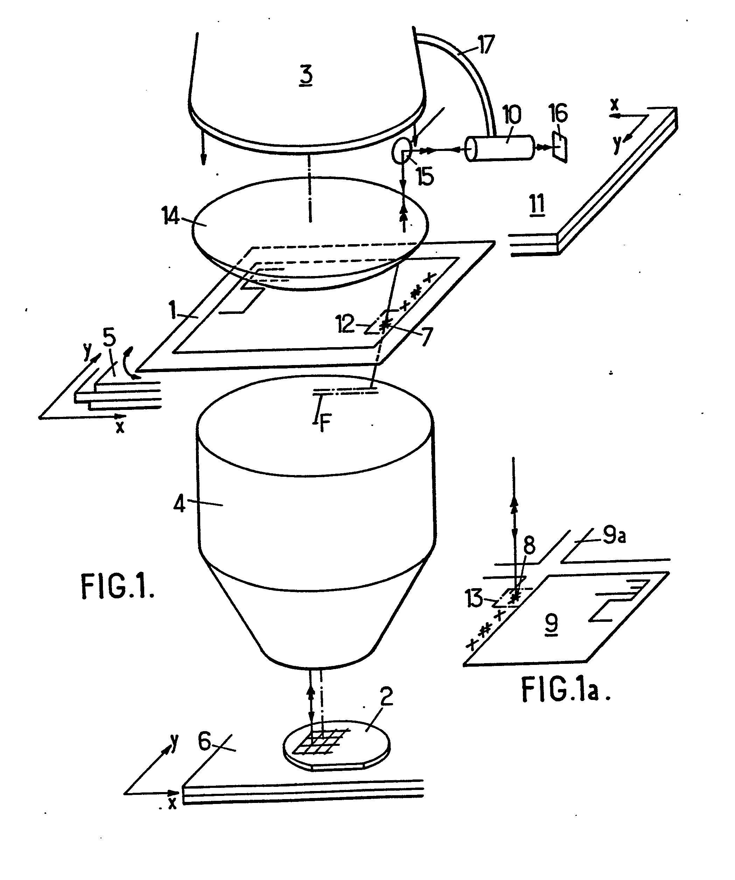

La machine de fabrication de circuits intégrés montrée schématiquement en Figure 1 est du type habituellement appelé "photo-répéteur sur tranche". Cette machine est destinée à reproduire à intervalles réguliers, sur la résine photosensible qui recouvre une tranche 2 de semiconducteur (silicium en général) le tracé dessiné sur un réticule ou masque 1. La constitution générale de la machine montrée en Figure est classique. Elle comporte un illuminateur 3 capable de fournir, pendant une durée bien déterminée, un faisceau parallèle de lumière actinique, une table porte-réticule 5, un objectif de photoréduction 4 destiné à recueillir la lumière qui a traversé le réticule et à former l'image de ce dernier sur la tranche de silicium 2, portée par une table 6. On ne décrira pas en détail les éléments mécaniques constitutifs, étant donné qu'ils peuvent avoir n'importe quelle constitution classique, par exemple celle décrite dans le brevet US-A- 4 153 371. Il suffit de noter que la table porte-réticule 5 est prévue pour permettre de déplacer le réticule suivant deux directions orthogonales x et y et en rotation autour d'un axe parallèle à l'axe optique de la machine. Cette table permet de régler l'orientation du réticule 1 de façon que les bords du tracé soient parallèles aux axes x et y. La table 6 permet de donner à la tranche 2 des déplacements suivant les directions x et y correspondant au pas de répétition du tracé sur la tranche.

Le réticule 1 porte non seulement le tracé de circuit à reproduire, mais aussi des motifs de référence 7 qui seront amenés à coincider avec des motifs d'alignement 8 portés par la tranche de façon à assurer l'alignement avec une précision qui doit être de l'ordre de 0,1 µm dans les deux directions x et y. On a représenté sur les Figs. 1 et 1a plusieurs motifs d'alignement successifs, tels que 8, pour chaque puce 9. La raison en est que, lorsqu'on utilise une résine photosensible positive, la couche de résine qui a été insolée disparait au développement, en même temps que le motif d'alignement qui vient d'être utilisé, de sorte que plusieurs peuvent être utilisés en succession lorsque la fabrication de la puce exige plusieurs expositions sous des réticules différents et plusieurs développements.

Les motifs sont placés soit dans la partie du tracé proche du bord, soit - pour utiliser au maximum la surface disponible de tranche dans les chemins 9a de découpe de la tranche 2 (Fig. 1a). Les motifs peuvent avoir des formes très diverses mais, en règle générale, ils comporteront des lignes croisées à 45° des directions x et y pour permettre l'alignement suivant ces deux directions.

Le dispositif d'alignement proprement dit comprend un microscope d'observation 10. Le microscope 10 est, lui aussi, monté sur une table 11 à déplacements croisés permettant de le déplacer dans deux directions orthogonales conjuguées des directions x et y du réticule et de la tranche. La table 11 peut être associée à un dispositif de commande de déplacement programmé pour provoquer des déplacements d'amplitude bien déterminée dans les deux directions. L'amplitude de la translation suivant la direction x, fixée une fois pour toutes pour une puce de dimensions données, permet de passer de l'observation d'une puce à celle de la suivante. La translation suivant la direction y permet de passer d'un motif d'alignement 8 sur la tranche (et du motif de référence correspondant 7 sur le réticule) au suivant.

Le microscope est muni d'une source de lumière à la longueur d'onde d'insolation, dont un mode particulier de réalisation sera décrit plus loin. Cette source permet d'éclairer une fenêtre 12 du réticule contenant le motif de référence 7 utilisé. L'objectif de photoréduction 4 forme une image de cette fenêtre sur une zone 13 de la tranche contenant le motif d'alignement 8. L'image du motif d'alignement 8 est, inversement, formée dans la fenêtre 12 par l'objectif de photoréduction 4. Ainsi, le microscope 10 reçoit la lumière réfléchie par la fenêtre 12 et la zone 13 et permet d'observer simultanément les motifs 7 et 8.

Pour que les rayons moyens incident et réfléchi sur la tranche 2 suivent des trajets confondus, le rayon incident doit passer par le foyer objet F de l'objectif de photoréduction 4 quel que soit le point du champ visé par le microscope 10. Pour remplir cette condition, le dispositif d'alignement comporte, immédiatement au-dessus du réticule 1, une lentille de champ 14 dont la focale est égale à la distance entre le réticule 1 et le foyer F. Ainsi, à condition que le rayon incident arrivant sur la lentille 14 soit parallèle à l'axe optique, le rayon réfracté passera toujours par F, quelle que soit la position du microscope 10. La lentille 14 influe très peu sur le grandissement et la qualité de l'image, puisqu'elle est à proximité de la fenêtre 12. Il suffira de lui donner une qualité optique comparable à celle de l'illuminateur 3. Pour que l'image soit satisfaisante, l'objectif de photoréduction 4 sera choisi tel que son foyer objet F soit au voisinage de sa pupille d'entrée. Dans la pratique, cette condition est généralement remplie par les objectifs habituels, qui sont de type télécentrique.

On a vu que le pinceau de lumière destiné à éclairer la fenêtre 12 doit être parallèle à l'axe optique. Le microscope 10 étant par contre placé latéralement, un miroir de visée 15, renvoyant la lumière à 90°, est placé sur le trajet optique entre le microscope 10 et la lentille 14. Les motifs de référence devant pouvoir être inscrits sur la résine recouvrant la tranche 2, le miroir 15 doit pouvoir être escamoté rapidement pour permettre l'insolation. Cette disposition permet de plus d'isoler l'image obtenue par réflexion directe sur le réticule 1 en plaçant un diaphragme 16 de forme appropriée. Le diaphragme 16 est placé au foyer image de l'objectif du microscope, où se forme l'image de la source incorporée au microscope, comme on le verra plus loin.

Un seul dispositif d'alignement a été montré sur la figure 1 mais on peut naturellement placer deux dispositifs qui visent des motifs placés respectivement dans les chemins de découpe droit et gauche.

La nécessité d'un miroir escamotable 15 (ou plus généralement d'un système optique commutable) n'impose pas de contrainte grave à la machine : en effet, le miroir 15 pouvant être très léger, les temps de mise en place et de retrait sont très brefs (par exemple 50 ms et 40 ms). Le temps nécessaire pour effectuer l'alignement à la précision nécessaire est également très bref, de l'ordre de 100 ms.

L'insolation, sous une intensité lumineuse très supérieure à celle utilisée lors de l'alignement, sera généralement de l'ordre de 100 ms également.

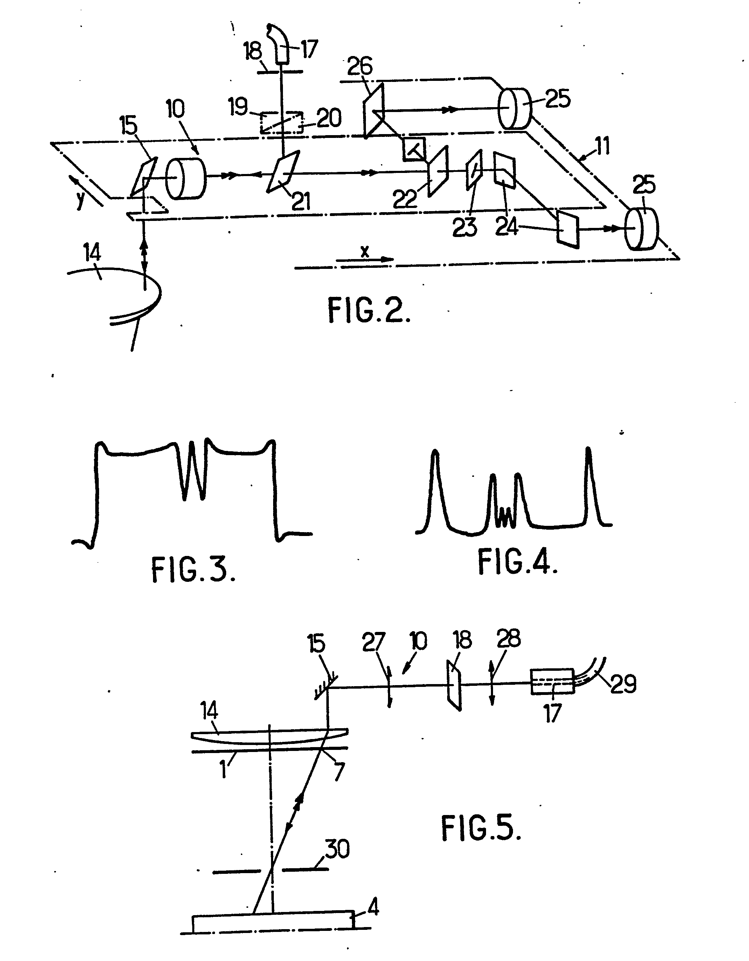

On décrira maintenant, en faisant référence à la figure 2, la constitution générale du microscope 10 et des organes associés (source et système d'analyse).

La source incorporée au microscope est constituée, dans le mode de réalisation montré en figures 1 et 2, par une fibre optique 17 suffisamment souple pour pouvoir suivre les déplacements du microscope. Cette fibre emprunte une fraction de la lumière provenant de la lampe d'insolation incorporée à l'illuminateur 3 (lampe au mercure en général). La lumière sortant de la tranche terminale de la fibre 17, constituant source, traverse un diaphragme de champ 18 et un diaphragme d'ouverture 19 au niveau duquel peut être placé un prisme de Wollaston 20 lorsqu'on souhaite réaliser un contraste interférentiel. Une lame semitransparente 21 renvoie le pinceau de lumière d'éclairage vers l'objectif du microscope 10.

La lumière réfléchie par la tranche 2, qui va former des images des motifs 7 et 8 est reprise par l'objectif du microscope, traverse la lame semitransparente 21 et est séparée en deux voies, analysant chacune l'une des directions des motifs. Un séparateur 22 (lame séparatrice semitransparente ou cube séparateur, éventuellement polarisant) répartit l'intensité lumineuse entre les deux voies qui ont une constitution similaire. La voie 1 par exemple comporte successivement un filtre spatial 23, des miroirs de renvoi 24 et un détecteur 25. Le filtre spatial 23, généralement constitué par un diaphragme à fente perpendiculaire à la direction d'analyse, est destiné à bloquer l'image provenant de la réflexion directe sur le réticule 1. Il est placé au foyer image de l'objectif, correspondant au plan de la pupille, c'est-à-dire au seul endroit où pratiquement les deux images sont séparées. Un prisme de Wollaston (non représenté) peut être également placé à proximité du foyer pour réaliser un contraste interférentiel lorsqu'on n'a qu'une image de phase.

Les miroirs 24 sur la voie 1 et 26 sur la voie 11 permettent de donner à l'image une position latérale constante, lorsque le microscope est déplacé suivant la direction y (figure 2) dans le champ de l'optique de réduction 4. Les translations latérales suivant la direction y sont ainsi transformées en translations longitudinales, suivant la direction x de déplacement global du dispositif d'analyse dans son entier. Le défaut de mise au point qui en résulte est dans la pratique compensé par la variation d'épaisseur traversée dans la lentille 14, lorsque le grandissement du microscope 10 est optimisé à cet effet.

Les détecteurs 25 peuvent être de types divers. Lorsqu'en particulier les motifs sont du genre montré en figures 1 et 1a, l'analyse d'image peut s'effectuer par exemple à l'aide d'un balayage à fente. La représentation obtenue est du genre montré en figure 3. La position du motif 8 sur la tranche est calculée après numérisation du signal par rapport au centre de la fenêtre d'analyse 12 et le recentrage est effectué par déplacement de la table 6. Avant traitement de signal, il est avantageux de le dériver, puis de redresser les pics négatifs de façon à arriver à la représentation de la figure 4. La mesure d'écart effectuée sur le signal permet ensuite d'effectuer l'alignement par déplacement en x et/ou en y de la table 5.

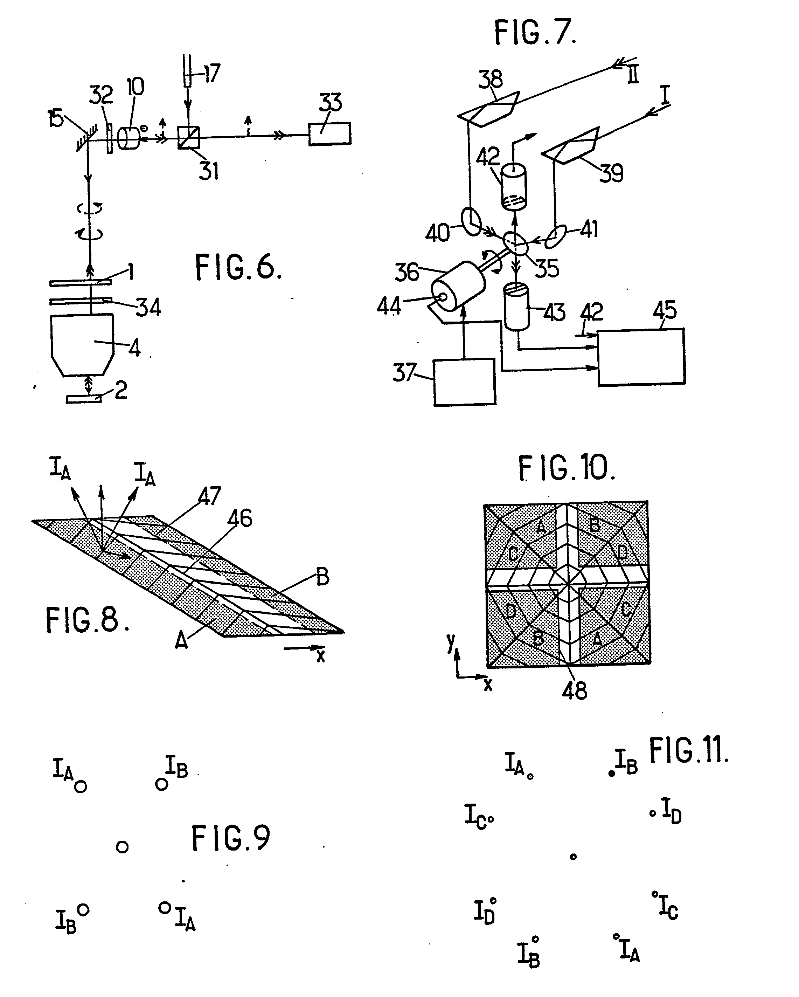

La figure 5 (où les organes correspondant à ceux de la figure 2 portent le même numéro de référence) décrit une variante de réalisation permettant un asservissement. La source est constituée par la tranche terminale d'une fibre optique 17 placée dans un plan conjugué de la pupille de l'objectif photoréducteur. Le champ éclairé est limité par un diaphragme de champ 18. Les figures de diffraction obtenues par projection du motif 7 du réticule sur le motif 8 de la tranche donnent naissance, à travers le motif 7, à une nouvelle image que le microscope 10 (lentilles 27 et 28) forme sur un détecteur. Ce détecteur peut être constitué par les tranches terminales, régulièrement réparties sur des cercles concentriques, d'un faisceau de fibres optiques 29. Ces tranches terminales sont placées dans un plan conjugué de la pupille d'entrée 30 de l'objectif photoréducteur 4. On peut ainsi faire une analyse dans ce plan de Fourier. Les tranches à une extrémité des fibres sont situées à l'emplacement de la figure de diffraction formée par les motifs du réticule et de la tranche, avantageusement constitués cette fois par des réseaux linéaires à pas constant. Les moyens d'analyse photoélectrique situés aux autres extrémités des fibres sont fixes par rapport à la machine.

Le dispositif d'alignement qui vient d'être décrit dans lequel les rayons passent toujours par le même chemin dans le microscope 10, permet de faire une analyse, donnant un signal d'erreur, dans le plan de la pupille de l'objectif photoréducteur en un point quelconque du champ.

Quel que soit le mode de réalisation adopté, l'optique commutable (miroir escamotable 15 par exemple) permet de ne donner à la résine qu'une insolation très faible au cours de l'alignement, et ce d'autant plus que ce dernier peut être fait en un temps très bref. Aucun déplacement de la tranche n'est nécessaire entre alignement et insolation, ce qui augmente la cadence de fonctionnement et supprime les problèmes de déplacement précis de la tranche sur de courtes distances. Le fait de devoir placer le microscope d'observation sur une table permettant de le déplacer dans les deux directions ne constituant pas, dans la pratique, une contrainte réelle, pas plus que l'adjonction de la lentille de champ 14.

L'invention est susceptible de nombreuses autres variantes de réalisation, entre lesquelles on pourra choisir suivant les conditions particulières d'utilisation.

La variante montrée en Figure 6, où les éléments correspondant à ceux des Figures 1 et 2 portent le même numéro de référence, est prévue pour fonctionner en lumière polarisée, afin de s'affranchir du problème de rétrodiffusion directe de la lumière sur les surfaces optiques du microscope. La lumière incidente provenant de la fibre optique 17 est polarisée par un cube 31 qui réfléchit la polarisation perpendiculaire. La lumière directe (indiquée par les flèches simples) traverse une lame quart d'onde 32 qui lui donne une polarisation circulaire droite. Par réflexion sur la tranche 2, la lumière prend une polarisation circulaire gauche (flèches doubles et sens de polarisation indiqué en tirets). La traversée de la lame quart d'onde 32 par la lumière réfléchie lui donne une polarisation linéaire, parallèle au plan d'incidence. Le cube 31 laisse passer complètement cette polarisation vers le dispositif d'alignement 33, qui peut avoir la constitution montrée en Figure 2.

La lame quart d'onde 32 peut être placée devant le microscope : la lumière rétrodiffusée par les optiques, présentant une polarisation perpendiculaire, sera réfléchie vers la fibre 17. On peut même mettre une lame quart d'onde 34, par exemple en mica, entre le réticule 1 et l'objectif de projection 4. On élimine alors la lumière rétrodiffusée par le réticule, qui est particulièrement gênante pour l'alignement.

Cette solution donne un gain global accru et renforce le contraste de certains détails, qui apparaissent mieux en lumière polarisée qu'en lumière naturelle.

On décrira maintenant, en faisant référence à la Figure 7, un système d'analyse d'image pouvant être incorporé au dispositif de la Figure 2. Ce système utilise un balayage à fente 11 comprend un déviateur à miroir 35 double dont le déplacement angulaire est commandé par un mécanisme 36 (mécanisme de galvanomètre par exemple) attaqué par un générateur de rampe linéaire 37. Sur chacune des voies 1 et 11 sont interposés un organe de rotation d'image 38 ou 39 et un miroir de renvoi 40 ou 41. On trouve par exemple, sur la voie 1, un prisme de Dove ou de Wollaston provoquant une rotation de 45° et un miroir 41 de déplacement d'image. Le miroir mobile à double face 35 permet de faire défiler l'image de chaque voie devant la fente, perpendiculaire à la direction d'analyse, d'entrée d'un photomultiplicateur correspondant 42 ou 43. Le galvanomètre 36 peut être muni d'un transducteur de position 44 relié à un circuit d'échantillonnage et de traitement 45 de type classique.

L'alignement par analyse d'image donne de bons résultats pour des tranches présentant de bons contrastes, donnant un signal de phase important. Mais dans d'autres cas, ce mode d'analyse se heurte à des difficultés. On peut alors lui préférer le système d'analyse par réseau qui sera maintenant décrit en faisant référence aux Figures 8 à 11.

La Figure 8 est destinée à montrer le principe mis en oeuvre dans un dispositif d'analyse à réseau de diffraction. Si on suppose tout d'abord que l'on cherche à effectuer l'alignement suivant une seule direction $x$, cet alignement est réalisé en soumettant à un éclairement égal deux zones de la tranche de semiconducteur qui ont été codées par des réseaux présentant des directions différentes, de façon à pouvoir les différencier. La Figure 8 montre deux zones adjacentes A et B de la tranche de silicium, en contact par un côté 46, sur lesquelles sont gravés des réseaux, obliques par rapport au côté commun 46 et symétriques. Lorsque ces réseaux sont éclairés en lumière quasi parallèle, ils diffractent suivant deux directions contenues dans un plan perpendiculaire à la direction des traits du réseau, et notamment selon les directions du premier ordre indiquées par $I_A$ sur la Figure 8 pour la zone A. Si on récupère ces ordres diffractés à l'aide d'un système optique, on obtient des points lumineux répartis autour d'une tache centrale correspondant à l'ordre 0, dont les positions sont définies par l'inclinaison des traits du réseau (Figure 9).

Si sur le réticule est prévue une fente d'éclairement 47, que l'on projette sur les zones A et B parallèlement à la direction du côté 46, on obtiendra dans les ordres diffractés des intensités $I_B$ et $I_A$ proportionnelles, pour chaque ordre, à la surface éclairée. Dans le cas montré en Figure 8, on aura $I_B > I_A$. Il suffit alors de déplacer la tranche jusqu'à rétablir l'égalité.

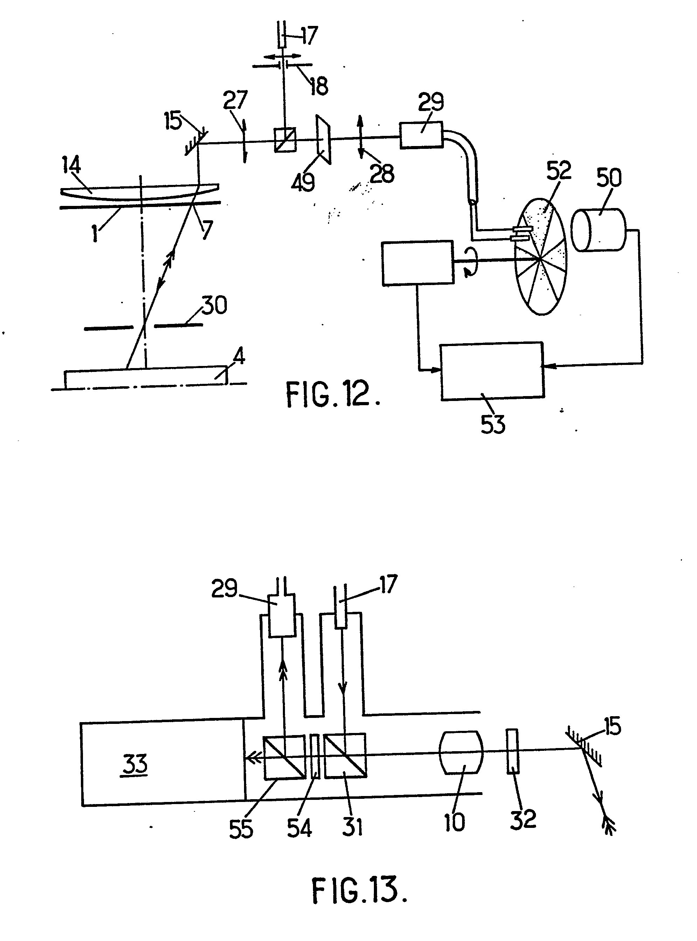

Dans le cas d'un dispositif où l'alignement doit s'effectuer selon deux directions perpendiculaires, on sera amené à prévoir quatre zones de diffraction, par exemple réparties comme indiqué sur la Figure 10, ce qui donnera naissance à un diagramme de diffraction du genre montré en Figure 11. Au lieu d'une fente, le réticule doit comporter une croix 48. Le signal $I_B$-$I_A$ donnera l'erreur d'alignement suivant la direction $x$ par exemple, le signal $I_C$-$I_D$ donnera l'erreur d'alignement suivant la direction $y$.

Ce système d'alignement à réseau de diffraction peut être disposé dans le photorépéteur comme indiqué schématiquement sur la Figure 12, où les éléments correspondant à ceux de la Figure 5 sont désignés par le même numéro de référence. L'image de la fibre 17 est formée au foyer objet de l'objectif de photoréduction 4, au moyen de l'objectif 27 et de la lentille 14. L'optique est prévue de façon que l'image du diaphragme de champ 18 se forme sur le réticule 1 de manière à éclairer le motif de référence 7, constitué par une croix transparente, ouverte dans le réticule 1. L'image de la croix est formée sur la tranche (non représentée) par l'objectif de photoréduction 4. Les ordres diffractés sont repris au foyer de cet objectif 4 et l'image en retour est reprise, à travers le réticule 1, par la lentille 14 et l'objectif 27 pour être reformée sur le diaphragme 49. La dernière lentille 28 renvoie cette image à l'infini et, en même temps, reforme l'image du plan focal de l'objectif de photoréduction 4 sur les tranches terminales des fibres optiques du faisceau 29. Ces tranches terminales sont réparties pour correspondre au diagramme de diffraction montré en Figure 11. Par exemple, on peut adopter des réseaux A et B placés à 22,5° et à -22,5° par rapport à la direction $x$, des réseaux C et D à 67,5° et -67,5°, par rapport à cette direction. Un second jeu de fibres peut être prévu de façon que leur tranche terminale recueille les interférences dans les ordres +3 et -3, au cas où les interférences seraient destructives dans le premier ordre. La détection du signal d'erreur peut s'effectuer en détectant les intensités provenant des fibres recueillant les intensités $I_A$ et $I_B$ à l'aide d'un photomultiplicateur 50 précédé d'un disque hacheur 52. Le signal de sortie du photomultiplicateur attaque un démodulateur synchrone 53 qui reçoit également un signal de référence du moteur d'entrainement du disque. Le signal alternatif, d'amplitude proportionnelle à l'erreur d'alignement, fourni par le photomultiplicateur, donne, après détection synchrone, un signal d'erreur analogique qui peut être réinjecté dans une boucle d'asservissement de la table 6. Le même traitement, appliqué aux fibres transmettant les intensités $I_C$ et $I_D$, permet d'obtenir un signal d'erreur de commande selon la direction $y$.

Pour permettre à l'utilisateur d'utiliser, à son choix, soit l'analyse d'image, soit l'analyse par réseau de diffraction, le dispositif d'alignement peut comporter les éléments nécessaires aux deux modes de fonctionnement et des moyens de commutation. La Figure 13 montre schématiquement une disposition hybride possible : une lame quart d'onde escamotable 54 permet de choisir soit la voie d'analyse par réseau de diffraction, vers le faisceau de fibres optiques, soit la voie d'analyse d'image à travers un cube polarisant 55.

## Revendications

1. Dispositif d'alignement pour machine de fabrication de circuits intégrés comprenant une table porte-réticule (5) portant un réticule et munie de moyens permettant de la déplacer dans son plan, au moins dans deux directions orthogonales $x$ et $y$ correspondant à deux axes principaux du réticule; une table (6) de réception d'une tranche de semi-conducteur portant au moins un motif d'alignement (8), ladite table étant équipée de moyens de déplacement suivant deux directions conjuguées des directions $x$ et $y$; une optique de photoréduction (4) disposée entre les tables; des moyens d'illumination du réticule en lumière actinique permettant d'insoler la tranche de semi-conducteur à travers l'optique (4); et des moyens d'observation simultanée destinés à rechercher la coïncidence entre un motif d'alignement sur la tranche et un motif de référence sur le réticule et comprenant un microscope (10) muni d'un élément optique (15) qui ramène, vers le microscope, la lumière d'éclairage réfléchie par le réticule et la lumière d'éclairage réfléchie par la tranche à travers l'optique de photoréduction (4), dispositif caractérisé en ce que l'élément optique (15) est commutable entre un état où il dégage le trajet du faisceau d'insolation et un état dans lequel il dirige un pinceau de lumière d'éclairage provenant d'une source incorporée au microscope et de même longueur d'onde que la lumière d'insolation, à travers le motif de référence vers la tranche.

2. Dispositif suivant la revendication 1, caractérisé en ce que l'élément optique (15) est constitué par un miroir de visée (15) déplaçable entre une position où il est à l'intérieur du faisceau d'insolation et une position où il est à l'extérieur.

3. Dispositif suivant la revendication 1 ou 2, caractérisé en ce qu'il comporte un lentille de champ (14) interposée entre l'illuminateur et le réticule, à proximité immédiate du réticule, dont le foyer est sensiblement confondu avec le foyer objet de l'optique de photoréduction (4).

4. Dispositif suivant l'une quelconque des revendications précédentes, caractérisé en ce que le microscope (10) est monté sur une table (11) à déplacement croisé permettant de le déplacer dans deux directions orthogonales conjuguées des directions x et y du réticule et de la tranche.

5. Dispositif suivant l'une quelconque des revendications précédentes, caractérisé en ce que la source du pinceau de lumière d'alignement est constitué par la tranche terminale d'un guide optique d'amenge de lumière à partir de l'illuminateur.

6. Dispositif suivant l'une quelconque des revendications précédentes, caractérisé en ce qu'il comprend une lame semitransparente (21) destinée à envoyer le pinceau de lumière incidente provenant de la source (17) vers l'optique commutable et à transmettre la lumière réfléchie vers un système d'analyse (22-26).

7. Dispositif suivant la revendication 6, caractérisé en ce que le système d'analyse comporte un séparateur (22) de fractionnement du pinceau réfléchi en deux voies, comportant chacune un filtre spatial (23) et un détecteur, chaque voie étant affectée à une direction particulière des motifs.

**Patentansprüche**

1. Justiereinrichtung für Maschinen zur Herstellung integrierter Schaltungen, die einen Achsenkreuztragetisch, der ein Achsenkreuz trägt und mit Mitteln versehen ist, die es erlauben, ihn in seiner Ebene, zumindest in zwei orthogonalen Richtungen X und Y, die zwei Hauptachsen des Achsenkreuzes entsprechen, zu verschieben;

einen Tisch (6) zur Aufnahme einer Halbleiterscheibe, die zumindest ein Justiermotiv (8) trägt, wobei der Tisch mit Verschiebungsmitteln ausgerüstet ist, die zwei mit den Richtungen X und Y gekoppelten Richtungen folgen; eine zwischen den Tischen angeordnete Lichtbildverkleinerungsoptik (4); Mittel zur Achsenkreuzbeleuchtung in aktinischem Licht, die es erlauben, die Halbleiterscheibe durch die Optik (4) hindurch zu bestrahlen; und Mittel zur gleichzeitigen Beobachtung, die dazu bestimmt sind, das Zusammentreffen zwischen einem Justiermotiv auf der Scheibe und einem Referenzmotiv auf dem Achsenkreuz zu suchen und die ein mit einem optischen Element (15) versehenes Mikroskop (10) umfaßt, daß, zu dem Mikroskop, das von dem Achsenkreuz reflektierte Beleuchtungslicht und das von der Scheibe durch die Lichtbildverkleinerungsoptik (4) hindurch reflektierte Beleuchtungslicht zurückbringt, umfaßt,

dadurch gekennzeichnet,

daß das optische Element (15) zwischen einem Zustand, wo es den Verlauf des Bestrahlungsstrahles abstrahlt und einem Zustand, in welchem es ein Beleuchtungslichtbündel, das einer in dem Mikroskop eingebauten Quelle entstammt und dieselbe Wellenlänge wie das Bestrahlungslicht hat, durch das Referenzmotiv hindurch zu der Scheibe lenkt.

2. Vorrichtung nach Anspruch 1, dadurch gekennzeichnet, daß das optische Element (15) aus einem Visierspiegel (15) gebildet ist, welcher zwischen einer Position, wo er sich innerhalb des Bestrahlungsstrahles befindet und einer Position, wo er sich außerhalb befindet, verschiebbar ist.

3. Vorrichtung nach Anspruch 1 oder 2, dadurch gekennzeichnet, daß sie aus einer Feldlinse (14) besteht, die zwischen dem Beleuchter und dem Achsenkreuz, in unmittelbarer Nähe des Achsenkreuzes, eingefügt ist und deren Brennpunkt ungefähr mit dem Objektbrennpunkt der Lichtbildverkleinerungsoptik (4) verschmilzt.

4. Vorrichtung nach einem der vorangehenden Ansprüche, dadurch gekennzeichnet, daß das Mikroskop (10) auf einem Tisch (11) zur kreuzartigen Verschiebung montiert ist, der es erlaubt, es in zwei orthogonalen Richtungen, die mit den Richtungen X und Y des Achsenkreuzes und der Scheibe gekoppelt sind, zu verschieben.

5. Vorrichtung nach einem der vorangehenden Ansprüche, dadurch gekennzeichnet, daß die Quelle des Lichtbündels der Justierung durch den Endabschnitt einer optischen Führung zur Zuführung von von dem Beleuchter ausgehendem Licht gebildet ist.

6. Vorrichtung nach einem der vorangehendne Ansprüche, dadurch gekennzeichnet,

daß sie eine dünne semitransparente Platte (21) umfaßt, die bestimmt ist, das einfallende Lichtbündel, das von der Quelle (17) herstammt, an die umschaltbare Optik zu geben und das reflektierte Licht an ein Analysesystem (22-26) weiterzuleiten.

7. Vorrichtung nach Anspruch 6,
dadurch gekennzeichnet,
daß das Analysesystem aus einem Separator (22) zur Aufteilung des reflektierten Bündels in zwei Wege besteht, von denen jeder einen Raumfilter (23) und einen Detektor umfaßt und wobei jeder Weg für eine besondere Richtung der Motive bestimmt ist.

## Claims

1. An alignment device for an apparatus for printing integrated circuits, comprising a reticle holding table (5) carrying a reticle and provided with means for moving it within its plane, at least along two mutually orthogonal directions x and y corresponding to two main axes of the reticle; a table (6) for receiving a semiconductor wafer provided with at least one alignment mark (8), said table being provided with means for moving it along two directions which are conjugate with directions x and y; photoreducing means (4) located between the tables; means for illuminating the reticle with actinic light for exposing the semiconductor wafer through said optical means (4); and means for simultaneous observation for determination of coincidence between an alignment mark on the wafer and a reference mark on the reticle, having a microscope (10) provided with an optical element (15) which brings back towards the microscope the illuminating light which is reflected by the reticle and the illuminating light reflected by the wafer through the photoreducing optical means (4),

characterized in that the optical element (15) is switchable between a condition where it is clear of the illuminating beam and a condition where it directs a thin beam of lighting light from a source incorporated to the microscope and having the same wave length as the illuminating light through the reference mark toward the wafer.

2. Device according to claim 1, characterized in that the optical element (15) consists of a sighting mirror (15) displaceable between a position inside the illuminating beam and a position outside said beam.

3. Device according to claim 1 or 2, characterized in that it comprises a field lens (14) interposed between the illuminating means and the reticle, close to said reticle, the focus of said field lens being substantially at the object focus of the photoreducing optical means (4).

4. Alignment device according to any one of the preceding claims, characterized in that the microscope (10) is carried by the cross-motion table (11) for moving the microscope along two mutually orthogonal directions which are conjugate of the directions x and y of the reticle and wafer.

5. Device according to any one of the preceding claims, characterized in that the source of the thin beam of alignment light consists of the end face of an optical guide for bringing light from the illuminating means.

6. Device according to any one of the preceding claims, characterized in that it comprises a semitransparent blade (21) for directing the thin beam of incident light from the source (17) toward the switchable optical means and transmitting the reflected light toward an alignement system (22-26).

7. Device according to claim 6, characterized in that the analyzing system comprises a separator (22) for splitting the reflected beam into two paths, each comprising a spatial filter (23) and a detector, each path being assigned to a particular direction of the mark.

FIG.1.

FIG.1a.

FIG.2.

FIG.3.

FIG.4.

FIG.5.

# FIG.6.

# FIG.7.

# FIG.8.

# FIG.9

# FIG.10.

# FIG.11.

FIG.12.

FIG.13.